(19) Europäisches Patentamt / European Patent Office / Office européen des brevets

(11) **EP 2 961 245 A1**

(12) **EUROPEAN PATENT APPLICATION**
published in accordance with Art. 153(4) EPC

(43) Date of publication:
**30.12.2015 Bulletin 2015/53**

(51) Int Cl.:
**H05B 33/04** (2006.01)　　**H01L 51/50** (2006.01)

(21) Application number: **14879012.4**

(22) Date of filing: **06.11.2014**

(86) International application number:
**PCT/JP2014/079472**

(87) International publication number:
**WO 2015/107754 (23.07.2015 Gazette 2015/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.01.2014 JP 2014004328**

(71) Applicant: **Nitto Denko Corporation**
**Ibaraki-shi, Osaka 567-8680 (JP)**

(72) Inventor: **YAMADA, Yasumi**
**Ibaraki-shi**
**Osaka 567-8680 (JP)**

(74) Representative: **Grünecker Patent- und**
**Rechtsanwälte**
**PartG mbB**
**Leopoldstraße 4**
**80802 München (DE)**

(54) **ORGANIC ELECTROLUMINESCENT DEVICE**

(57) An organic electroluminescence device 1 of the present invention includes a support substrate 2, an organic electroluminescence element 3, a moisture absorbing layer 4 which contains a component having moisture absorption, and a moisture-barrier layer 5 which is provided on the moisture absorbing layer 4 and which contains a component having moisture barrier, wherein a plurality of mixed layers 61, 62, and 63, each of which contains a component having moisture absorption and a component having moisture barrier, exists between the moisture absorbing layer 4 and the moisture-barrier layer 5, and among the plurality of mixed layers, a mixed layer 61 on the moisture absorbing layer 4 side has a higher content of the component having moisture absorption as compared to a mixed layer 63 on the moisture-barrier layer 5 side.

Fig. 2

EP 2 961 245 A1

**Description**

TECHNICAL FIELD

The present invention relates to an organic electroluminescence device.

BACKGROUND ART

Hereinafter, the organic electroluminescence is referred to as "organic EL".
Conventionally, the organic EL device including a support substrate and an organic EL element provided on the support substrate is known. The organic EL element includes a first electrode, a second electrode, and an organic layer provided between the first and second electrodes.
The organic EL element is easily degraded by moisture. For example, Patent Document 1 discloses an organic EL device including an organic EL element provided on a support substrate, a moisture absorbing layer provided on the organic EL element, and a gas barrier layer provided on the moisture absorbing layer for preventing degradation caused by moisture of the organic EL element. The moisture absorbing layer in Patent Document 1 is formed of a metal oxide such as calcium oxide or strontium oxide, and the gas barrier layer is formed of silicon nitride, silicon oxide or silicon nitride oxide. The gas barrier layer corresponds to a moisture-barrier layer.
According to the organic EL device in Patent Document 1, permeation of moisture into the organic EL device can be prevented by the gas barrier layer, and further, the moisture absorbing layer provided between the gas barrier layer and the organic EL element absorbs moisture, so that degradation caused by moisture of the organic EL element can be suppressed.
However, when the moisture absorbing layer absorbs moisture, the moisture absorbing layer is expanded in volume, and therefore the gas barrier layer may be partially peeled off from the moisture absorbing layer, or the gas barrier layer and the moisture absorbing layer may be cracked. When the peeling or cracking occurs, moisture permeates from the affected part into the organic EL element to degrade the organic EL element. Thus, conventional organic EL devices have a short light emission life, and it is required to improve the light emission life.
[Patent Document 1] JP 2011-020335 A

SUMMARY OF THE INVENTION

An object of the present invention is to provide an organic EL device having a long light emission life by preventing peeling between a moisture-barrier layer and a moisture absorbing layer, etc.
An organic EL device includes a support substrate, an organic EL element provided on the support substrate, a moisture absorbing layer which is provided on the organic EL element and which contains a component having moisture absorption, and a moisture-barrier layer which is provided on the moisture absorbing layer and which contains a component having moisture barrier, wherein a plurality of mixed layers, each of which contains a component having moisture absorption and a component having moisture barrier, exists between the moisture absorbing layer and the moisture-barrier layer, and among the plurality of mixed layers, a mixed layer on the moisture absorbing layer side has a higher content of the component having moisture absorption as compared to a mixed layer on the moisture-barrier layer side.
Preferably, the mixed layer on the moisture absorbing layer side has a lower content of the component having moisture barrier as compared to the mixed layer on the moisture-barrier layer side.
Preferably, the plurality of mixed layers includes first, second, and third mixed layers which are stacked in this order from the moisture absorbing layer side to the moisture-barrier layer side, and the contents of the components having moisture absorption in the mixed layers satisfy the relationship: content of component having moisture absorption in first mixed layer > content of component having moisture absorption in second mixed layer > content of component having moisture absorption in third mixed layer.
Preferably, the contents of the components having moisture barrier in the first, second, and third mixed layers satisfy the relationship: content of component having moisture barrier in first mixed layer < content of component having moisture barrier in second mixed layer < content of component having moisture barrier in third mixed layer.
The organic EL device of the present invention can stably emit light over a long period of time as a moisture-barrier layer is hardly peeled off from a moisture absorbing layer.

BRIEF DESCRIPTION OF THE DRAWINGS

Fig. 1 is a sectional view of an organic EL device of the present invention (sectional view of the organic EL device taken along a thickness direction).
Fig. 2 is an enlarged sectional view of a main part of an organic EL device according to one embodiment, where unlike Fig. 1, Fig. 2 illustrates the organic EL element as one layer (the same applies to Figs. 3 and 4).
Fig. 3 is an enlarged sectional view of a main part of an organic EL device according to another embodiment.
Fig. 4 is an enlarged sectional view of a main part of an organic EL device according to still another embodiment.
Fig. 5 is a schematic view of a vapor deposition apparatus for forming a moisture absorbing layer, a mixed layer, and a moisture-barrier layer.

Hereinafter, the present invention will be described with reference to the drawings. It should be noted that dimensions such as a layer thickness and a length in the drawings are different from actual dimensions.
In this specification, the terms "first" and "second" may be added as prefixes. These prefixes are only added in order to distinguish the terms. The wording "PPP to QQQ" indicates "PPP or more and QQQ or less".

[Configuration of Organic EL Device]

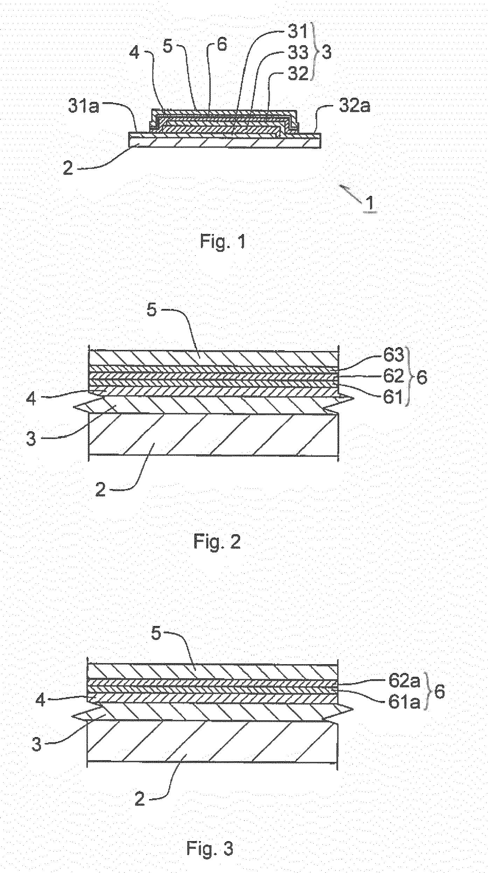

An organic EL device 1 of the present invention includes a support substrate 2, an organic EL element 3 provided on the support substrate 2, a moisture absorbing layer 4 provided on the organic EL element 3, a mixed layer 6 provided on the moisture absorbing layer 4, and a moisture-barrier layer 5 provided on the mixed layer 6 as illustrated in Fig. 1. The mixed layer 6 includes a plurality of mixed layers 61, 62, and 63 as illustrated in Fig. 2. Among the plurality of mixed layers 61, 62, and 63, the mixed layer 61 on the moisture absorbing layer 4 side has a higher content of the component having moisture absorption as compared to the mixed layer on the moisture-barrier layer 5 side. The mixed layer 61 on the moisture absorbing layer 4 side has a lower content of the component having moisture barrier as compared to the mixed layer on the moisture-barrier layer 5 side. The moisture absorption means a quality of absorbing moisture. The moisture barrier means a quality of preventing permeation of moisture. In this specification, the content refers to a percentage (%) by volume where the overall volume is set to 100%. For example, the content of the component having moisture absorption in the mixed layer is determined from the formula: (volume of component having moisture absorption / volume of whole mixed layer) × 100, and the content of the component having moisture barrier in the mixed layer is determined from the formula:

$$(\text{volume of component having moisture barrier} / \text{volume of whole mixed layer}) \times 100.$$

Hereinafter, the component having moisture absorption is referred to as a "moisture absorbing component", and the component having moisture barrier is referred to as a "moisture-barrier component". For distinguishing a plurality of mixed layers from one another, the term "first", "second", etc. is added as a prefix to the mixed layer in this order from the moisture absorbing layer side to the moisture-barrier layer side. A plurality of mixed layers may be referred to collectively as a "mixed layer".
As illustrated in Fig. 1, the organic EL element 3 includes a first electrode 31 having a terminal 31a, a second electrode 32 having a terminal 32a, and an organic layer 33 provided between the both electrodes 31 and 32.
For example, the terminal 31a of the first electrode 31 is arranged on a first side and the terminal 32a of the second electrode 32 is arranged on a second side with respect to the organic layer 33. The first side and the second side are mutually opposite sides. The moisture absorbing layer 4, the mixed layer 6, and the moisture-barrier layer 5 are stacked and bonded so as to cover a surface of the organic EL element 3 excepting the terminals 31a and 32a.
When the substrate 2 has electric conductivity, an insulating layer (not illustrated) is provided between the substrate 2 and the first electrode 31 in order to prevent an electrical short-circuit.
Specifically, the organic EL element 3 is formed into a substantially rectangular shape in a planar view, for example. Of course, a planar shape of the organic EL element 3 is not limited to a substantially rectangular shape, but it may be shaped like a substantially square or circular shape.
The organic layer 33 of the organic EL element 3 includes a light emitting layer, and has various kinds of functional layers such as a hole transport layer and an electron transport layer, as necessary. The layer configuration of the organic layer 33 is described later.
For forming the terminal 31a of the first electrode 31, the organic layer 33 is provided on the surface of the first electrode 31 excepting the end part (terminal 31a) of the first electrode 31 arranged on the first side.
The second electrode 32 is provided on the surface of the organic layer 33 so as to cover the surface of the organic layer 33. For forming the terminal 32a of the second electrode 32, the end part (terminal 32a) of the second electrode 32 is drawn from the end part of the organic layer 33 to the second side.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

The moisture absorbing layer 4 is a layer that absorbs moisture. By providing the moisture absorbing layer 4, a slight amount of moisture passing through the moisture-barrier layer 5 is absorbed into the moisture absorbing layer 4, and therefore degradation caused by moisture of the organic EL element 3 can be effectively suppressed. The moisture absorbing layer 4 is stacked on the second electrode 32. In other words, the moisture absorbing layer 4 is provided between the second electrode 32 and the moisture-barrier layer 5.

The moisture-barrier layer 5 is a layer for preventing permeation of moisture (water vapor) etc. into the organic EL element 3. The moisture-barrier layer 5 is stacked on the mixed layer 6 so as to cover the moisture absorbing layer 4.

The mixed layer 6 functions as a binder layer for integrating the moisture absorbing layer 4 and the moisture-barrier layer 5. The mixed layer 6 may be provided so as to exist in a part of the gap between the moisture absorbing layer 4 and the moisture-barrier layer 5, but preferably, the mixed layer 6 is provided so as to exist in the whole of the gap between the moisture absorbing layer 4 and the moisture-barrier layer 5.

As illustrated in Fig. 2, the first mixed layer 61 is stacked on the moisture absorbing layer 4. The second mixed layer 62 is stacked on the first mixed layer 61. The third mixed layer 63 is stacked on the second mixed layer 62. The moisture-barrier layer 5 is stacked on the third mixed layer 63. Preferably, the contents of the moisture absorbing component and the moisture-barrier component contained in the first, second, and third mixed layers 61, 62, and 63 satisfy the following relationships:

content of moisture absorbing component in first mixed layer 61 > content of moisture absorbing component in second mixed layer 62 > content of moisture absorbing component in third mixed layer 63; and
content of moisture-barrier component in first mixed layer 61 < content of moisture-barrier component in second mixed layer 62 < content of moisture-barrier component in third mixed layer 63.

The ratio of the moisture absorbing component and the moisture-barrier component contained in the first, second and third mixed layers 61, 62 and 63 is not particularly limited. For example, the ratio of moisture absorbing component : moisture-barrier component in the first mixed layer 61 is 90 : 10 to 60 : 40 (volume ratio), the ratio of moisture absorbing component: moisture-barrier component in the second mixed layer 62 is 60 : 40 to 40 : 60 (volume ratio), and the ratio of moisture absorbing component: moisture-barrier component in the third mixed layer 63 is 40 : 60 to 10 : 90 (volume ratio).

The moisture absorbing layer 4, the mixed layer 6, and the moisture-barrier layer 5 airtightly covers the whole of the organic EL element 3 excepting the terminals 31a and 32a. Specifically, the moisture absorbing layer 4 is airtightly bonded on a surface of the second electrode 32 excepting the terminals 31a and 32a, and airtightly bonded on a peripheral end surface of the organic EL element 3 as illustrated in Fig. 1. The peripheral edge of the moisture absorbing layer 4 is bonded on a surface of the first electrode 31 and a surface of the second electrode 32. The peripheral end surface of the organic EL element 3 is a peripheral surface that forms a thickness of the element 3. Since the moisture-barrier layer 5 is stacked on the outside of the moisture absorbing layer 4, the peripheral end surface of the organic EL element 3 is also covered with the moisture-barrier layer 5. The mixed layer 6 is airtightly bonded on the whole of a surface of the moisture absorbing layer 4, and airtightly bonded on the back surface of the moisture-barrier layer 5.

In the example illustrated in Fig. 2, the mixed layer 6 has a three-layer structure, but the structure of the mixed layer 6 is not limited thereto, and for example, the mixed layer 6 may include a first mixed layer 61a stacked on the moisture absorbing layer 4 and a second mixed layer 62a stacked on the first mixed layer 61a as illustrated in Fig. 3.

Similarly, in the example illustrated in Fig. 3, the contents of the component having moisture absorption and moisture barrier contained in the first and second mixed layers 61a and 62a satisfy the following relationships:

content of moisture absorbing component in first mixed layer 61a > content of moisture absorbing component in second mixed layer 62a; and content of moisture-barrier component in first mixed layer 61a < content of moisture-barrier component in second mixed layer 62a.

The ratio of the moisture absorbing component and the moisture-barrier component contained in the first and second mixed layers 61a and 62a is not particularly limited. For example, the ratio of moisture absorbing component : moisture-barrier component in the first mixed layer 61a is 90 : 10 to 50 : 50 (volume ratio), and the ratio of moisture absorbing component: moisture-barrier component in the second mixed layer 62a is 50 : 50 to 10 : 90 (volume ratio).

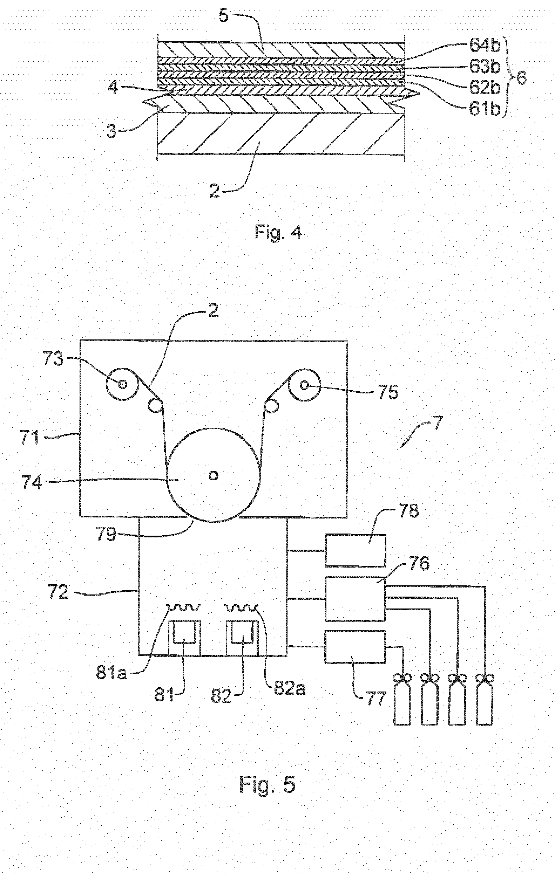

The mixed layer 6 does not necessarily have a two- or three-layer structure, and may include four or more layers. For example, Fig. 4 illustrates the mixed layer 6 having a four-layer structure. In Fig. 4, the mixed layer 6 may include a first mixed layer 61b stacked on the moisture absorbing layer 4, and second, third, and fourth mixed layers 62b, 63b, and 64b that are sequentially stacked thereon.

Similarly, in the example illustrated in Fig. 4, the contents of the component having moisture absorption and moisture barrier contained in the first to fourth mixed layers 61b, 62b, 63b, and 64b satisfy the following relationships:

content of moisture absorbing component in first mixed layer 61b > content of moisture absorbing component in second mixed layer 62b > content of moisture absorbing component in third mixed layer 63b > content of moisture absorbing component in fourth mixed layer 64b;
content of moisture-barrier component in first mixed layer 61b < content of moisture-barrier component in second mixed layer 62b < content of moisture-barrier component in third mixed layer 63b < content of moisture-barrier component in fourth mixed layer 64b.

The ratio of the moisture absorbing component and the moisture-barrier component contained in the first to fourth mixed layers 61b, 62b, 63b, and 64b is not particularly limited. For example, the ratio of moisture absorbing component : moisture-barrier component in the first mixed layer 61b is 95 : 5 to 70 : 30 (volume ratio), the ratio of moisture absorbing component: moisture-barrier component in the second mixed layer 62b is 70 : 30 to 50 : 50 (volume ratio), the ratio of moisture absorbing component : moisture-barrier component in the third mixed layer 63b is 50 : 50 to 30 : 70 (volume ratio), and the ratio of moisture absorbing component : moisture-barrier component in the fourth mixed layer 64b is 30 : 70 to 5 : 95 (volume ratio).

In the example illustrated in Fig. 1, the moisture absorbing layer 4, the mixed layer 6, and the moisture-barrier layer 5 are provided so as to cover even the peripheral end surface of the organic EL element 3, but the moisture absorbing layer 4 and/or the mixed layer 6 and/or the moisture-barrier layer 5 may be provided so as to cover only a surface of the second electrode 32 without covering the peripheral end surface of the organic EL element 3 (not illustrated).

Any appropriate functional layer may be provided between the support substrate 2 and the organic EL element 3, or between the organic EL element 3 and the moisture absorbing layer 4, or on a surface of the moisture-barrier layer 5 (the functional layer is not illustrated).

[Support Substrate]

The support substrate is a sheet-shaped material, preferably a flexible sheet-shaped material. The support substrate may be either transparent or opaque. However, a transparent support substrate is used when a bottom-emission type organic EL device is formed. Either a transparent support substrate or an opaque support substrate may be used when a top-emission type organic EL device is formed. The transparency means colorless transparency or colored transparency. The index for the transparency may be, for example, a total light transmittance of 70% or more, preferably 80% or more. It is to be noted that the total light emittance is measured by a measurement method conforming to JIS K7105 (Method for Testing Optical Characteristics of Plastics).

The support substrate to be used in the present invention is a substrate which is excellent in gas barrier properties so that permeation of moisture and oxygen can be prevented. For example, the support substrate may be appropriately selected from a metal sheet, a resin sheet, a glass sheet, a ceramic sheet, and the like. In this specification, the "sheet" also includes what is generally called a "film". The metal sheet is not particularly limited, and examples thereof include flexible thin plates composed of stainless steel, copper, titanium, aluminum, alloys, and the like. A thickness of the metal sheet is 10 $\mu$m to 100 $\mu$m, for example. The resin sheet is not particularly limited, and examples thereof include synthetic resin sheets such as those of polyester-based resins such as polyethylene terephthalate (PET), polyethylene naphthalate (PEN), and polybutylene terephthalate (PBT); olefin-based resins having an $\alpha$-olefin as a monomer component, such as polyethylene (PE), polypropylene (PP), polymethylpentene (PMP), ethylene-propylene copolymers, and ethylenevinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). A thickness of the resin sheet is not particularly limited, and is, for example, 10 $\mu$m to 200 $\mu$m. A known gas barrier layer may be stacked on at least one surface of the resin sheet so that satisfactory gas barrier properties can be imparted.

For preventing a rise in temperature of the organic EL device at the time of driving, the support substrate is preferably excellent in heat dissipation. When a conductive substrate (metal sheet etc.) is used as the support substrate, an insulating layer is provided on a surface of the support substrate for insulating the support substrate against an opposite electrode.

[Moisture Absorbing Layer]

The moisture absorbing layer is a layer having a quality of absorbing moisture (moisture absorption). The formation material of the moisture absorbing layer is not particularly limited as long as it contains a component having moisture absorption. Examples of the moisture absorbing component include boron compounds; sulfides; oxides of alkali metals or alkali earth metals; fluorides, sulfates, halides, phosphates or perchlorates of alkali metals or alkali earth metals.

The moisture absorbing component is at least one of a boron compound and a sulfide, more preferably a boron compound or a sulfide because a moisture absorbing layer can be easily formed using a vacuum deposition method.

The boron compound is a compound containing a boron atom in the molecule thereof, and examples thereof include oxides of boron, oxygen acids of boron and bromides of boron. Examples of the oxide of boron include boron oxide ($B_2O_3$). The oxygen acid of boron is an oxygen acid with a boron atom as a central atom, or a salt thereof. Examples of the oxygen acid of boron include orthoboric acid, metaboric acid, hypoboric acid, tetraboric acid, pentaboric acid, and sodium salts, potassium salts and ammonium salts thereof. Examples of the bromide of boron include boron tribromide ($BBr_3$). Among them, boron oxide is preferable because it is excellent in moisture absorption. Boron oxide is also excellent in transparency, and therefore suitable as a formation material of a moisture absorbing layer of a top-emission type organic EL device.

Examples of the sulfide include zinc sulfide.

Examples of the alkali metal or alkali earth metal include Li, Na, K, Rb, Cs, Fr, Be, Mg, Ca, Sr, and Ba. Examples of the oxide of an alkali metal or alkali earth metal include sodium oxide, potassium oxide, calcium oxide, barium oxide and magnesium oxide. Examples of the fluoride of an alkali metal etc. include lithium fluoride, calcium fluoride, magnesium fluoride, and sodium fluoride. Examples of the sulfate of an alkali metal etc. include lithium sulfate, sodium sulfate, and calcium sulfate. Examples of the halide of an alkali metal etc. include calcium chloride, magnesium chloride, and calcium bromide. Examples of the phosphate of an alkali metal etc. include calcium phosphate. Examples of the perchlorate of an alkali metal etc. include barium perchlorate and magnesium perchlorate.

Preferably, the moisture absorbing layer is composed only of a moisture absorbing component, but the moisture absorbing layer may also contain a component that does not have moisture absorption as long as it contains a moisture absorbing component.

Here, in this specification, the phrase "composed only of ...component" means that existence of a very small amount of other components that are inevitably contained is allowed, and existence of a significant amount of other components is excluded.

When the moisture absorbing layer contains a component that does not have moisture absorption, the amount of the component is 10% by volume or less, preferably 5% by volume or less with respect to the moisture absorbing layer.

A thickness of the moisture absorbing layer is not particularly limited, and is, for example, 5 nm to 500 nm, preferably 20 nm to 200 nm, more preferably 30 nm to 200 nm.

[Moisture-barrier Layer]

The moisture-barrier layer is a layer having a quality of preventing permeation of moisture etc. into the organic EL element. The formation material of the moisture-barrier layer is not particularly limited as long as it contains a component having moisture barrier. Examples of the moisture-barrier component include compounds containing a metal or a semimetal. The semimetal is a substance having a nature that is somewhere between a metal and a nonmetal. Examples of the metal include the above-mentioned alkali metals and alkali earth metals, and other metals. Examples of metals other than alkali metals and alkali earth metals include titanium, aluminum, zinc, gallium, indium and magnesium. Examples of the semimetal include silicon, germanium, arsenic, antimony, tellurium, and astatine. It is preferable that the moisture-barrier component contains at least one of carbon and nitrogen because a network structure (reticulated structure) in the moisture-barrier layer can be densely formed, and barrier properties to gases such as water vapor and oxygen can be improved. Further, it is preferable that the moisture-barrier component contains oxygen because a moisture-barrier layer excellent in transparency can be formed.

Accordingly, the moisture-barrier component is more preferably at least one selected from a nitride of a metal or a semimetal, a carbide of a metal or a semimetal, a nitride oxide of a metal or a semimetal, a carbide oxide of a metal or a semimetal, a nitride carbide of a metal or a semimetal, and a nitride carbide oxide of a metal or a semimetal, more preferably at least one selected from a nitride oxide of a metal or a semimetal, a carbide oxide of a metal or a semimetal, a nitride carbide of a metal or a semimetal, and a nitride carbide oxide of a metal or a semimetal. As the moisture-barrier component, for example, at least one selected from a nitride of silicon, a nitride oxide of silicon, a carbide oxide of silicon, a nitride carbide of silicon, and a nitride carbide oxide of silicon can be used. The nitride, nitride oxide, nitride carbide, and nitride carbide oxide of silicon may be silicon nitride, silicon nitride oxide, silicon nitride carbide, and silicon nitride carbide oxide, respectively.

Preferably, the moisture-barrier layer is composed only of a moisture-barrier component, but the moisture-barrier layer may contain other components as long as it contains a moisture-barrier component.

When the moisture-barrier layer contains a component other than a moisture-barrier component, the amount of the component is 10% by volume or less, preferably 5% by volume or less with respect to the moisture-barrier layer.

A thickness of the moisture-barrier layer is not particularly limited, and is, for example, 50 nm to 2000 nm, preferably 100 nm to 1000 nm.

[Mixed Layer]

The mixed layer contains a moisture absorbing component and a moisture-barrier component, and includes a plurality of layers as described above.

The content of each of the moisture absorbing component and the moisture-barrier component in the plurality of mixed layers (first mixed layer and so on) is not constant, but is changed stepwise as described above.

The moisture absorbing component contained in the plurality of mixed layers is of the same kind as the moisture absorbing component forming the moisture absorbing layer, and is preferably identical to the moisture absorbing component forming the moisture absorbing layer. The "same kind" means that the components are compounds that belong to the same category in classification (for example, when the moisture absorbing component forming the moisture absorbing layer is a boron compound, the moisture absorbing component of the mixed layer is also included in the category of boron compounds), and the "being identical" means that the components can be represented by the same chemical formula. The moisture-barrier component contained in the mixed layer is of the same kind as the moisture-barrier component forming the moisture-barrier layer, and is preferably identical to the moisture-barrier component forming the moisture-barrier layer. Similarly to the case of the moisture-absorbing component, the "same kind" means that the components are compounds that belong to the same category in classification, and the "being identical" means that the components can be represented by the same chemical formula.

The moisture absorbing component and the moisture-barrier component in each of the plurality of mixed layers may be chemically bonded, or are not required to be chemically bonded. The "being chemically bonded" means that atoms that form the moisture absorbing component and atoms that form the moisture-barrier component are covalently bonded.

The thickness of the mixed layer is not particularly limited, and is, for example, 10 nm to 1000 nm, preferably 20 nm to 100 nm. The thicknesses of the mixed layers (first mixed layer, second mixed layer and so on) are not particularly limited, and are mutually independently, for example, 5 nm to 100 nm, preferably 10 nm to 50 nm. The mixed layers (first mixed layer, second mixed layer and so on) may have the same thickness, or may have mutually different thicknesses.

[Organic EL Element Having First Electrode, Organic Layer and Second Electrode]

The first electrode may be either an anode or a cathode. The first electrode is an anode, for example.

The formation material of the first electrode (anode) is not particularly limited, and examples include indium tin oxide (ITO); indium tin oxide including silicon oxide (ITSO); aluminum; gold; platinum; nickel; tungsten; copper; and an alloy. When a bottom emission organic EL device is formed, a transparent first electrode is used.

A thickness of the first electrode is not particularly limited, and it is usually 10 nm to 1.0 $\mu$m, preferably 50 nm to 200 nm.

An organic layer is a laminate structure composed of at least two layers. Examples of a structure of the organic layer include (A) a structure composed of three layers including a hole transport layer, a light emitting layer, and an electron transport layer; (B) a structure composed of two layers including a hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a hole transport layer.

The organic layer used in the present invention can have any of the structures (A) to (C) mentioned above.

The organic layer having the structure (A) in the case of where the first electrode is an anode is explained below.

The hole transport layer is provided on the surface of the first electrode. An arbitrary function layer other than the first electrode and the hole transport layer may be interposed between the first electrode and the hole transport layer under the conditions in which the light emitting efficiency of the organic EL element is not lowered.

For example, the hole injection layer may be provided on the surface of the first electrode, and the hole transport layer may be provided on the surface of the hole injection layer. The hole injection layer is a layer having a function of aiding injection of a hole from the anode layer to the hole transport layer.

A formation material of the hole transport layer is not particularly limited as long as the formation material has a hole transport function. Examples of the formation material of the hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)benzidine (abbreviation: $\alpha$-NPD) and N,N'-bis(naphthalene-1-yl)-N,N'-bis(phenyl)-9,9'-spiro-bisfluorene (abbreviation: Spiro-NPB); a polymer compound; and the like. The formation material of the hole transport layer may be used alone or in combination of two or more formation materials. Furthermore, the hole transport layer may be a multi-layer structure having two or more layers.

A thickness of the hole transport layer is not particularly limited, but the thickness of 1 nm to 100 nm is preferable from the viewpoint of reducing drive voltage.

A light emitting layer is provided on the surface of the hole transport layer.

A formation material of the light emitting layer is not particularly limited as long as it has light emitting property. Examples of the formation material of the light emitting layer include a low molecular light emission material such as a low molecular fluorescence emission material and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (abbreviation: Alq$_3$), and the like.

Furthermore, as the formation material of the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)$_3$), tris(1-phenyl isoquinoline)iridium (III) (Ir(piq)$_3$), and bis(1-phenyl isoquinoline) (acetylacetonato) iridium (III) (abbreviation: Ir(piq)$_2$(acac)), and the like.

Furthermore, the formation material of the light emitting layer may include such as the formation material of the hole transport layer mentioned above, the formation material of the electron transport layer mentioned below, and various additives.

A thickness of the light emitting layer is not particularly limited, and is, for example, preferably 2 nm to 100 nm.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer may be provided on the surface of the electron transport layer, and the second electrode may be provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq$_3$), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl] benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used alone or in combination of two or more types. Furthermore, the electron transport layer may have a multi-layered structure composed of two or more layers.

A thickness of the electron transport layer is not particularly limited, and is preferably 1 nm to 100 nm from the viewpoint of reducing drive voltage.

A second electrode may be either a cathode or an anode. The second electrode is a cathode, for example.

A formation material of the second electrode is not particularly limited, but a transparent second electrode is used when a top emission organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, and is usually 10 nm to 1.0 μm, preferably 50 nm to 200 nm.

[Use and Effect of Organic EL Device]

The organic EL device of the present invention, alone or in combination of two or more of the organic EL devices, can be used as a light emitting panel of an illuminating device or an image display.

The organic EL device of the present invention is provided with a moisture-barrier layer, so that permeation of moisture into the device can be prevented. Further, a moisture absorbing layer is provided between the organic EL element and the moisture-barrier layer, and therefore when a slight amount of moisture passes through the moisture-barrier layer, the moisture absorbing layer absorbs the moisture. Accordingly, permeation of moisture into the organic EL element can be prevented.

Generally, as the moisture absorbing layer absorbs moisture, the moisture absorbing layer is expanded to distort the moisture-barrier layer. As a result, the moisture-barrier layer is partially peeled off from the moisture absorbing layer, or the moisture-barrier layer and the moisture absorbing layer are cracked. Moisture permeates from the peeled part or cracked part into the organic EL element.

In the organic EL device of the present invention, a plurality of mixed layers each containing both a moisture absorbing component and a moisture-barrier component is provided between the moisture absorbing layer and the moisture-barrier layer. The mixed layer on the moisture-absorbing layer side contains a moisture absorbing component in a large amount, and the mixed layer on the moisture-barrier layer side contains a moisture-barrier component in a large amount. The moisture absorbing component in the mixed layer can also absorb moisture. Accordingly, the degree of expansion when the moisture absorbing component in each of the moisture absorbing layer and the mixed layer absorb moisture decreases stepwise toward the moisture-barrier layer. As a result, distortion is hard to occur in the moisture-barrier layer, and the moisture absorbing layer and the mixed layer, and the moisture-barrier layer and the mixed layer are hard to be separated from each other. In the present invention, the moisture absorbing layer and the moisture-barrier layer are integrated with each other with a plurality of mixed layers interposed therebetween, and therefore occurrence of cracking can be effectively prevented. Accordingly, the organic EL device of the present invention continues to stably emit light over a long period of time.

[Method for Producing Organic EL Device]

The method for producing an organic EL device according to the present invention includes a moisture absorbing layer forming step of forming a moisture absorbing layer on an organic EL element formed on a support substrate; a mixed layer forming step of forming a mixed layer on the moisture absorbing layer; and a moisture-barrier layer forming step of forming a moisture-barrier layer on the mixed layer.

For the organic EL device of the present invention, a plurality of organic EL devices can be continuously produced by a roll-to-roll method, or organic EL devices can be produced using a sheet-like support substrate.

A method for continuously producing a plurality of organic EL devices by a roll-to-roll method will be described below.

The method for producing an organic EL device by a roll-to-roll method includes an element forming step of forming a plurality of organic EL elements on the flexible long belt-shaped support substrate; a moisture absorbing layer forming step of forming a moisture absorbing layer on the organic EL element; a mixed layer forming step of forming a plurality of mixed layers on the moisture absorbing layer; and a moisture-barrier layer forming step of forming a moisture-barrier layer on the mixed layer.

Fig. 5 illustrates a vapor deposition apparatus 7 for producing an organic EL device.

The vapor deposition apparatus 7 includes a first chamber 71; a second chamber 72; a first roll 73, a drum 74 and a second roll 75 each disposed at a predetermined position in the first chamber 71; vapor deposition sources 81 and 82 and shutters 81a and 82a each provided in the second chamber 72; a reaction gas feeder 76 that feeds a reaction gas into the second chamber 72; a discharge gas feeder 77 that feeds a discharge gas into the second chamber 72; and a vacuum pump 78 that brings the inside of the second chamber 72 into a vacuum state. The first roll 73, the drum 74 and the second roll 75 form a conveyor that conveys the long belt-shaped support substrate 2. The belt-shaped support substrate 2 is unwound from the first roll 73, made to pass over the drum 74, and wound around the second roll 75. By reversely rotating the first roll 73 and the second roll 75, the support substrate 2 wound around the second roll 75 can be unwound from the second roll 75, made to pass over the drum 74, and wound around the first roll 73.

While the first chamber 71 and the second chamber 72 are separated from each other by a partition wall, the first chamber 71 and the second chamber 72 partially communicate with each other through an opening 79. The first roll 73, the drum 74, and the second roll 75 are disposed in the first chamber 71, and a part of the drum 74 is exposed to the second chamber 72 side from the opening 79. The vapor deposition sources 81 and 82 are disposed in the second chamber 72 so as to face the opening 79. For vaporizing the materials of the vapor deposition sources 81 and 82, a heating unit (not illustrated) is provided. The heating unit is, for example, a resistance heating unit, an electron beam unit or the like. One of the two vapor deposition sources 81 and 82 is referred to as the first vapor deposition source 81, and the other is referred to as the second vapor deposition source 82.

A material that forms a moisture absorbing component is put in the first vapor deposition source 81, and a material that forms a moisture-barrier component is put in the second vapor deposition source 82. For example, when the moisture absorbing component is boron oxide, boron oxide is put in the first vapor deposition source 81. When the moisture-barrier component is a silicon compound, a silicon compound is put in the second vapor deposition source 82.

The vacuum pump 78 is operated to keep the inside of the second chamber 72 in a vacuum state. The pressure in the second chamber 72 is in a range of, for example, 0.01 Pa to 100 Pa, preferably 0.02 Pa to 10 Pa.

The long belt-shaped support substrate 2 is a long and narrow rectangular flexible sheet-shaped material. The length of the long belt-shaped support substrate (length in the long direction) is not particularly limited, and is, for example, 10 m to 1000 m, and the width of the support substrate (width in the short direction) is not particularly limited, and is, for example, several millimeters to 1000 mm, preferably 10 mm to 300 mm.

(Element forming step)

The step of forming the organic EL elements is performed similarly to a conventional step.

Briefly, the unwound support substrate 2 is cleaned in a cleaning tank and dried as needed. After the cleaning and drying step, the first electrode is formed on the surface of the support substrate 2.

As the formation method of the first electrode, an optimum method can be employed depending on the formation material thereof, and examples of the method include a sputtering method, a vacuum deposition method, and an ink-jet method. In a case where an anode is formed of metal, the vacuum deposition method is used. Furthermore, the support substrate having the first electrode previously patterned may be used. In the case where the support substrate has the previously formed first electrode, it is cleaned and dried after unwound from the roll.

An organic layer is formed on the surface of the first electrode excepting a terminal thereof. An organic layer can be formed by forming a hole transport layer, a light emitting layer, and an electron transport layer in this order on the surface of the first electrode, for example. As the formation method of the hole transport layer, the light emitting layer, and the electron transport layer, an optimum method can be employed depending on the formation material thereof, and examples of the method include a sputtering method, a vacuum deposition method, an ink-jet method, a coating method, and the like. Those layers are usually formed by the vacuum deposition method.

Subsequently, the second electrode is formed on the surface of the organic layer. The second electrode is formed so as not to cover the terminal of the first electrode. As the formation method of the second electrode, an optimum method can be employed depending on the formation material thereof, and examples of the method include a sputtering method, a vacuum deposition method, an ink-jet method, and the like.

The interval between the organic EL elements is not particularly limited and may be appropriately set. For example, the interval between the organic EL elements is 0.5 mm to 5 mm.

(Moisture Absorbing Layer Forming Step)

The moisture absorbing layer forming step is a step of forming a moisture absorbing layer on the organic EL element.

The support substrate 2 after formation of the organic EL element is wound around the second roll 75 through the drum 74 from the first roll 73 while the shutter 81a for the first vapor deposition source 81 is opened and the shutter 82a for the second vapor deposition source 82 is closed. The moisture absorbing component (boron oxide) is deposited on the organic EL element while the support substrate 2 passes through the second chamber 72 from the opening 79, so that a moisture absorbing layer is formed. The vapor deposition rate of the moisture absorbing component of the moisture absorbing layer is, for example, 0.1 nm/s to 30 nm/s.

(Mixed Layer Forming Step)

The mixed layer forming step is a step of forming a plurality of mixed layers on the moisture absorbing layer.

The support substrate 2 after formation of the moisture absorbing layer is wound around the second roll 75 as described above. The support substrate 2 after formation of the moisture absorbing layer is wound around the first roll 73 through the drum 74 from the second roll 75 while the shutters 81a and 82a for the first vapor deposition source 81 and the second vapor deposition source 82 are opened.

In formation of a first mixed layer with the content of the moisture absorbing component being higher than that of the moisture-barrier component, control is performed so that the vapor deposition rate of the material of the first vapor deposition source 81 is higher than the vapor deposition rate of the material of the second vapor deposition source 82. By appropriately controlling the vapor deposition rate of each of the material that forms the moisture absorbing component and the material that forms the moisture-barrier component, a mixed layer containing desired contents of a moisture absorbing component and a moisture-barrier component can be easily and conveniently formed by co-deposition. The vapor deposition rate can be controlled by adjusting, for example, the degree of opening/closing of the shutters 81a and 82a, and the amount of heating of the vapor deposition sources.

The support substrate 2 after formation of the first mixed layer is wound around the first roll 73. Subsequently, the vapor deposition rate of each of the materials of the moisture absorbing component and the moisture-barrier component is controlled while the support substrate 2 after formation of the first mixed layer is wound around the second roll 75 through the drum 74 from the first roll 73, so that a second mixed layer is formed. As necessary, this operation is repeated to sequentially form a third mixed layer and a fourth mixed layer in the same manner. In this manner, a mixed layer including a plurality of layers as illustrated in Figs. 2 to 4 can be stacked on the moisture absorbing layer.

(Moisture-barrier Layer Forming Step)

The moisture-barrier layer forming step is a step of forming a moisture-barrier layer on the mixed layer.

The support substrate 2 after formation of the mixed layer is made to pass over the drum 74 while the shutter 81a for the first vapor deposition source 81 is closed and the shutter 82a for the second vapor deposition source 82 is opened. The moisture-barrier component is deposited on the mixed layer while the support substrate 2 passes through the second chamber 72, so that a moisture-barrier layer is formed. The vapor deposition rate of the moisture-barrier component of the moisture-barrier layer is, for example, 0.1 nm/s to 30 nm/s.

As a method for depositing the moisture-barrier component, an optimum method may be employed, and examples thereof include physical vapor deposition methods and chemical vapor deposition methods. It is preferable that among them, a physical vapor deposition method using a plasma or a chemical vapor deposition method using a plasma is used to deposit the moisture-barrier component of the mixed layer and the moisture-barrier layer, and particularly a plasma vacuum deposition method is more preferable.

The plasma is not particularly limited, and for example, an arc discharge plasma, a glow discharge plasma, or the like may be used. An arc discharge plasma is preferably used because a very high electron density is achieved unlike a glow discharge plasma. As an arc discharge plasma generation source, for example, a pressure gradient type plasma gun, a direct-current discharge plasma generator, a high-frequency discharge plasma generator, or the like may be used. Among them, a pressure gradient type plasma gun is preferably used as the plasma source because a high-density plasma can be stably generated.

When the moisture absorbing component is at least one selected from a nitride, a carbide, a nitride oxide, a nitride carbide, and a nitride carbide oxide of a metal or a semimetal, a metal or a semimetal, or a nitride, a carbide, a nitride oxide, a nitride carbide, or a nitride carbide oxide thereof is put in the second vapor deposition source 82. When a metal or a semimetal is put in the second vapor deposition source 82, a nitrogen-containing gas, a nitrogen-oxygen-containing gas, a nitrogen-hydrocarbon-containing gas, or a nitrogen-oxygen-hydrocarbon-containing gas is used as a reaction gas. Examples of the nitrogen-containing gas include nitrogen ($N_2$), ammonia ($NH_3$), and nitrogen monoxide (NO). Examples of the nitrogen-oxygen-containing gas include nitrogen monoxide (NO), dinitrogen monoxide ($N_2O$), mixed gases of nitrogen ($N_2$) and oxygen ($O_2$). Examples of the nitrogen-hydrocarbon-containing gas include mixed gases of the nitrogen-containing gas and a hydrocarbon-containing gas. Examples of the hydrocarbon-containing gas include methane ($CH_4$), ethane ($C_2H_6$), propane ($C_3H_8$), butane ($C_4H_{10}$), ethylene ($C_2H_4$), and acetylene ($C_2H_2$). Examples of the nitrogen-oxygen-hydrocarbon-containing gas include mixed gases of the nitrogen-containing gas, an oxygen-containing gas, and a hydrocarbon-containing gas, and mixed gases of a nitrogen-oxygen-containing gas and a hydrocarbon-containing gas.

Specifically, for example, when the moisture-barrier component is silicon oxide nitride, silicon is put in the second vapor deposition source 82, and a nitrogen-oxygen-containing gas is used as a reaction gas.

In the second chamber 72 in a vacuum state, a discharge gas is introduced from the discharge gas feeder 77 into a plasma generation source (not illustrated) to generate a plasma. Further, by introducing a reaction gas from the reaction gas feeder 76 into the second chamber 72, and vaporizing the material from the vapor deposition source, the moisture-barrier component can be deposited.

In this manner, an organic EL device of the present invention can be produced.

In the above-mentioned production method, formation of a plurality of mixed layers by co-deposition of a moisture absorbing component and a moisture-barrier component has been shown as an example, but the method for forming mixed layers is not limited to co-deposition. For example, a plurality of mixed layers may be each formed by a mixing vapor deposition method in which materials to form a moisture absorbing component and a moisture-barrier component at a predetermined ratio are put in one vapor deposition source, and deposited.

When an organic EL device is produced by a batch processing system using a sheet-like support substrate, the sheet-like support substrate may be disposed in the opening 79 in Fig. 5, followed by sequentially forming thereon a moisture absorbing layer, a plurality of mixed layers, and moisture-barrier layer.

EXAMPLES

Hereinafter, the present invention is described in detail with reference to following Examples and Comparative Examples. However, the present invention is not limited to the following Examples.

[Example 1]

(Formation of organic EL Element)

On a surface of a commercial sheet-like glass substrate, aluminum was vacuum-deposited in a thickness of 150 nm to form an anode. On the surface of the anode, α-NPD (N,N'-bis(naphthalene-1-yl)-N,N'-bis(phenyl)benzidine) was vacuum-deposited in a thickness of 60 nm to form a hole transport layer. On the surface of the hole transport layer, $Alq_3$ (tris(8-quinolinolato)aluminum) was vacuum-deposited in a thickness of 40 nm to form a light emitting layer. On the surface of the light emitting layer, lithium fluoride was vacuum-deposited in a thickness of 1 nm to form an electron injection layer. On the surface of the electron injection layer, ITO (indium tin oxide) was vacuum-deposited in a thickness of 100 nm to form a cathode.

(Formation of Moisture Absorbing Layer, Mixed Layer, and Moisture-barrier Layer)

A moisture absorbing layer was formed on the surface of the cathode by vacuum-depositing $B_2O_3$ (boron oxide) in a thickness of 20 nm (vapor deposition rate: 1nm/s) using a vapor deposition apparatus as illustrated in Fig. 5 (batch processing system using a sheet-like support substrate).
A first mixed layer of $B_2O_3$ : SiON (silicon oxide nitride) = 7 : 3 (volume ratio) was formed on the surface of the moisture absorbing layer. The first mixed layer was formed by co-deposition with the vapor deposition rate of $B_2O_3$ controlled to 0.7 nm/s and the vapor deposition rate of SiON controlled to 0.3 nm/s. A thickness of the first mixed layer was 20 nm.
Next, a second mixed layer of $B_2O_3$ : SiON = 5 : 5 (volume ratio) was formed on the surface of the first mixed layer. The second mixed layer was formed by co-deposition with the vapor deposition rate of $B_2O_3$ controlled to 0.5 nm/s and the vapor deposition rate of SiON controlled to 0.5 nm/s. A thickness of the second mixed layer was 20 nm.
Furthermore, a third mixed layer of $B_2O_3$ : SiON = 3 : 7 (volume ratio) was formed on the surface of the second mixed layer. The third mixed layer was formed by co-deposition with the vapor deposition rate of $B_2O_3$ controlled to 0.3 nm/s and the vapor deposition rate of SiON controlled to 0.7 nm/s. A thickness of the third mixed layer was 20 nm.
On the surface of the third mixed layer, SiON was vacuum-deposited in a thickness of 300 nm (vapor deposition rate: 1 nm/s) to form a moisture-barrier layer.
For vapor deposition of SiON, a pressure gradient-type plasma gun was used as a plasma source, silicon particles were used as a vapor deposition source, and nitrogen ($N_2$) and oxygen ($O_2$) were used as reaction gases.
In this manner, a top-emission type organic EL device was prepared. See Fig. 2 for the layer configuration of the organic EL device.

(Configuration of Organic EL Device of Example 1)

Moisture-barrier layer: SiON with a thickness of 300 nm
Third mixed layer: thickness: 20 nm, $B_2O_3$ : SiON = 3 : 7
Second mixed layer: thickness: 20 nm, $B_2O_3$ : SiON = 5 : 5
First mixed layer: thickness: 20 nm, $B_2O_3$ : SiON = 7 : 3
Moisture absorbing layer: $B_2O_3$ with a thickness of 20 nm
Cathode: ITO with a thickness of 100 nm
Electron injection layer: LiF with a thickness of 1 nm
Light emitting layer: $Alq_3$ with a thickness of 40 nm
Hole transport layer: α-NPD with a thickness of 60 nm
Anode: Al with a thickness of 150 nm
Substrate: glass substrate

[Comparative Example 1]

An organic EL device was prepared in the same manner as in Example 1 except that a mixed layer was not formed (i.e. a moisture-barrier layer was formed directly on the surface of a moisture absorbing layer).

[Comparative Example 2]

An organic EL device was prepared in the same manner as in Example 1 except that the first mixed layer and the third mixed layer were interchanged with each other.

(Configuration of Organic EL Device of Comparative Example 2)

Moisture-barrier layer: SiON with a thickness of 300 nm
Third mixed layer: thickness: 20 nm, $B_2O_3$ : SiON = 7 : 3
Second mixed layer: thickness: 20 nm, $B_2O_3$ : SiON = 5 : 5
First mixed layer: thickness: 20 nm, $B_2O_3$: SiON = 3 : 7
Moisture absorbing layer: $B_2O_3$ with a thickness of 20 nm
Cathode: ITO with a thickness of 100 nm
Electron injection layer: LiF with a thickness of 1 nm
Light emitting layer: $Alq_3$ with a thickness of 40 nm
Hole transport layer: $\alpha$-NPD with a thickness of 60 nm
Anode: Al with a thickness of 150 nm
Substrate: glass substrate

[Comparative Example 3]

An organic EL device was prepared in the same manner as in Example 1 except that the first mixed layer and the third mixed layer were not formed, and only one mixed layer ($B_2O_3$ : SiON = 5 : 5) was formed in a thickness of 60 $\mu$m between a moisture absorbing layer and a moisture-barrier layer.

(Configuration of Organic EL Device of Comparative Example 3)

Moisture-barrier layer: SiON with a thickness of 300 nm
Mixed layer: thickness: 60 nm, $B_2O_3$ : SiON = 5 : 5
Moisture absorbing layer: $B_2O_3$ with a thickness of 20 nm
Cathode: ITO with a thickness of 100 nm
Electron injection layer: LiF with a thickness of 1 nm
Light emitting layer: $Alq_3$ with a thickness of 40 nm
Hole transport layer: $\alpha$-NPD with a thickness of 60 nm
Anode: Al with a thickness of 150 nm
Substrate: glass substrate

[Measurement of Light Emission Life of Organic EL Device]

For each of Examples and Comparative Examples, one organic EL device was arbitrarily selected, incorporated in an experimental circuit, stored at 60°C and 90% RH, and made to emit light over a long period of time by applying a voltage. The brightness at the initial stage of light emission was set to 100%, and time until the brightness decreased to 70% was measured.
The results thereof are shown in Table 1.

[Table 1]

|  | Time elapsed (h) |
|---|---|
| Example 1 | 400 |
| Comparative Example 1 | 100 |
| Comparative Example 2 | 150 |
| Comparative Example 3 | 300 |

As is evident from Table 1, the organic EL device of Example 1 emitted light over a relatively long period of time. In each of Example 1 and Comparative Example 2, a plurality of mixed layers each containing a moisture absorbing component and a moisture-barrier component is provided between the moisture absorbing layer and the moisture-barrier layer. However, in Comparative Example 2 where the mixed layer on the moisture absorbing layer side (first mixed layer) contained a moisture-barrier component in an amount larger than the amount of a moisture absorbing component, the life is much shorter as compared to Example 1. From this result, it is apparent that when the mixed layer on the moisture absorbing layer side contains a moisture absorbing component in an amount larger than the amount of a moisture-barrier component, the organic EL device has significantly increased light emission time.

INDUSTRIAL APPLICABILITY

The organic EL device of the present invention can be used for illuminating devices, image displays, or the like.
1 Organic EL device, 2 Support substrate, 3 Organic EL element, 4 Moisture absorbing layer, 5 Moisture-barrier layer, 61,62,63 A plurality of mixed layers

**Claims**

1.  An organic electroluminescence device comprising: a support substrate; an organic electroluminescence element provided on the support substrate; a moisture absorbing layer which is provided on the organic electroluminescence element and which contains a component having moisture absorption; and a moisture-barrier layer which is provided on the moisture absorbing layer and which contains a component having moisture barrier, wherein
    a plurality of mixed layers, each of which contains a component having moisture absorption and a component having moisture barrier, exists between the moisture absorbing layer and the moisture-barrier layer, and
    among the plurality of mixed layers, a mixed layer on the moisture absorbing layer side has a higher content of the component having moisture absorption as compared to a mixed layer on the moisture-barrier layer side.

2.  The organic electroluminescence device according to claim 1, wherein the mixed layer on the moisture absorbing layer side has a lower content of the component having moisture barrier as compared to the mixed layer on the moisture-barrier layer side.

3.  The organic electroluminescence device according to claim 1 or 2, wherein the plurality of mixed layers includes first, second, and third mixed layers which are stacked in this order from the moisture absorbing layer side to the moisture-barrier layer side, and the contents of the components having moisture absorption in the mixed layers satisfy the relationship: content of component having moisture absorption in first mixed layer > content of component having moisture absorption in second mixed layer > content of component having moisture absorption in third mixed layer.

4.  The organic electroluminescence device according to claim 3, wherein the contents of the components having moisture barrier in the first, second, and third mixed layers satisfy the relationship: content of component having moisture barrier in first mixed layer < content of component having moisture barrier in second mixed layer < content of component having moisture barrier in third mixed layer.

Fig. 1

Fig. 2

Fig. 3

Fig. 4

Fig. 5

## INTERNATIONAL SEARCH REPORT

International application No.

PCT/JP2014/079472

| A. CLASSIFICATION OF SUBJECT MATTER |
|---|
| *H05B33/04*(2006.01)i, *H01L51/50*(2006.01)i |

According to International Patent Classification (IPC) or to both national classification and IPC

| B. FIELDS SEARCHED |
|---|

Minimum documentation searched (classification system followed by classification symbols)
H05B33/04, H01L51/50

Documentation searched other than minimum documentation to the extent that such documents are included in the fields searched

| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y | JP 2011-20334 A (Dainippon Printing Co., Ltd.), 03 February 2011 (03.02.2011), paragraphs [0044], [0147], [0148]; fig. 1, 2, 7 (Family: none) | 1-4 |
| Y | JP 2008-214677 A (Toyota Central Research and Development Laboratories, Inc.), 18 September 2008 (18.09.2008), paragraph [0033] & US 2008/0211066 A1 | 1-4 |

☐ Further documents are listed in the continuation of Box C. ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 21 November, 2014 (21.11.14) | 09 December, 2014 (09.12.14) |

| Name and mailing address of the ISA/ Japanese Patent Office | Authorized officer |
|---|---|
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011020335 A